# EUROPEAN PATENT APPLICATION

(11) **EP 3 196 013 A1**
(43) Date of publication of application: **26.07.2017**
(21) Application number: 16152014.3
(22) Date of filing: 20.01.2016
(51) Int. Cl.: B32B 17/10, H01L 51/44

(54) **ORGANIC PHOTOVOLTAIC ASSEMBLY AND PROCESS OF MANUFACTURE**

(71) Applicant: AGC Glass Europe, 1348 Louvain-la-Neuve (BE); Heliatek GmbH, 01139 Dresden (DE); Asahi Glass Company, Limited, Chiyoda-ku Tokyo 100-8405 (JP); AGC Glass Company North America, Alpharetta GA 30022-1167 (US)
(72) Inventor: DEMEYERE, MICHAEL, 5380 FORVILLE (BE); POOT, BENOIT, 5030 GEMBLOUX (BE); GUTTOWSKI, AARON, 01097 DRESDEN (DE); HERMENAU, MARTIN, 0175 FREITAL (DE)
(74) Representative: Chabou, Samia

(57) **Abstract**

An organic photovoltaic assembly 1 comprising a first glass layer 2, a film comprising an organic photovoltaic component 4, at least one interlayer 3 or 5 or 7 with a water vapour transmission rate (WVTR) expressed in g/m²day less than 40 and having a processing temperature lower or equal to 120°C and a substrate 6.

## Description

### Technical domain of the invention

The field of the present invention relates to buildings or land vehicles for housing people or transporting people, or any other element such as street furniture, noise barriers, greenhouses, balustrades, louvers or double skin glasses, which comprise glazing panels with an organic photovoltaic device comprising a thermoplastic interlayer and to the process for obtaining the assembly.

### Background of the invention

Photovoltaic (PV) modules and cells based on inorganic wafers are well known. PV modules based on thin film modules, rather than on wafers have also been developed.

On the other hand, organic photovoltaic modules and cells have been published. Usually organic photovoltaic devices comprise at least two electrodes, and at least one photoactive layer and optionally various other doped and/or un-doped layers between the electrodes. The other layers have different functions, for instance carrier transport, blocking or passivation layers. The photoactive layers of some published photoactive components comprise layers with small molecules. These photoactive layers are often formed as mixed layers for getting highly efficient devices. In the context of the present invention, small molecules are understood to be non-polymeric organic molecules having monodisperse molar masses of between 100 and 2000. In particular, these small molecules can also be photoactive, wherein photoactive is understood to mean that the molecules change their charge state under light incidence (WO 2004 083 958 A2, WO 2006 092 134 A1, WO 2011161 108 A1) where the quantum efficiency of the charge transfer process is enhanced by electric fields and appropriate heterojunctions between donor-type and acceptor-type molecules.

WO 2009 151 952 A2 discloses a thin film PV module comprising a base substrate, a thin film PV device in contact with the base substrate, a poly(vinyl butyral) layer (PVB) disposed in contact with the PV device and a protective substrate.

Beside PV, WO 2014 083 110 A1 discloses a similar stack of an organic LED assembly, comprising two glasses, an interlayer, which can be made of EVA, and an organic light emitting diode.

Despite the efforts made to have well sealed PV modules, water diffusion to the functional film is a big challenge specifically associated with organic PV in that water will degrade the functional molecules and its electrode interfaces. In addition, depending on their nature, associated polymers or their constituting monomers used for lamination processes may react with organic PV molecules, which will thus reduce the efficiency or the lifetime.

Several reports, e.g. Hülsmann et al. (2009), "Measuring temperature-dependent water vapour and gas permeation through high barrier films" Review of Scientific Instruments, 80, 113901 and Peike et al. (2012) "Impact of Permeation properties and backsheet-encapsulant interactions on the reliability of PV modules" International Scholarly Research Network, Volume 2012, Article ID 459731, have shown that all thermoplastic interlayers have different profile of water vapour penetration value and damp heat tests results.

Regarding the protection of the organic PV film, water diffusion, may be an issue not only for its life time but also for its aesthetics.

In view of the prior art cited above, not all thermoplastic interlayers are suitable for the lamination of an organic PV film. Indeed not all thermoplastic interlayer are a good barrier for water.

### Technical Problem

In other words, there is the need to develop organic PV modules but - according to the literature cited above - the development of organic PV should be based on interlayers selected for their capacity of blocking water diffusion, thereby stabilizing the functional film.

To this end, and to the contrary to these assumptions, the Applicant submits his invention, which is an assembly comprising a first glass layer, a film comprising a functional photovoltaic (PV) organic molecule, a thermoplastic interlayer having a value of water vapour transmission rate (WVTR) expressed in g/m² /day less than 40 and having a processing temperature lower or equal to 120°C, and a substrate.

According to the present invention, the WVTR value corresponds to the value of the thermoplastic interlayer after lamination and measured at a temperature of 85°C, which is the temperature level of the damp heat test.

The WVTR is a measure of the passage of water vapour through a substance and in the present invention through a thermoplastic interlayer.

Particularly, the WVTR is measured according to the method described in the following article already cited above: Peike et al. (2012) "Impact of Permeation properties and backsheet-encapsulant interactions on the reliability of PV modules" International Scholarly Research Network, Volume 2012, Article ID 459731.

According to the present invention, the temperature of processing should be understood as the temperature used during the lamination process.

According to the invention, the use of such a thermoplastic interlayer prevents the organic photovoltaic film against damage due to humidity.

These particular thermoplastic interlayers are selected for their capacity to block water diffusion and their performances to well laminate an assembly comprising at least a glass substrate and a functional organic photovoltaic film. For example, an ionomer based interlayer will be difficult to process at a so low temperature (120°C), leading to bad lamination results (e.g. higher haze value).

Preferably, the film comprising an organic photovoltaic component is placed between two layers of a thermoplastic interlayer having a value of water vapour transmission rate (WVTR) expressed in g/m²/day less than 40 and having a processing temperature lower or equal 120°C.

### Brief description of figures

Figures 1 and 2 are a cross-sectional view of the assembly of the present invention.
Figure 3 is a table showing results of the damp heat obtained with an interlayer according or not to the present invention.

### Detailed description of the invention

The Applicant has successfully developed an assembly 1 comprising a functional film including an organic photovoltaic (PV) component 4, based on polymers or organic small molecules as an alternative to inorganic PV cells made of silicon wafers, amorphous or microcrystalline silicon thin films or any other inorganic PV technology.

The organic photovoltaic component (4) is a single, a tandem or a multiple organic photovoltaic component.

On the other hand, the environment causes heating of the assembly, heat variation, light radiation and water diffusion inside the assembly. All these conditions markedly affect the organic PV component and there is the need to select interlayers 3 and/or 5 for the capacity to protect the organic photovoltaic component 4, especially against water diffusion.

The applicants suggest an assembly 1 comprising a first glass module 2, a functional film of a photovoltaic component 4 preferred with organic molecules in the photoactive layer, and at least one interlayer 3, 5, or 7.

### Example: 1 Incorporation of the organic PV and of the PVB interlayer in a PV assembly

The assembly 1 comprises a first glass module 2, a functional film of a photovoltaic component 4 preferred with organic molecules, at least one interlayer 3, 5, or 7 and a substrate 6.

One or more films 3 of PVB are applied on a first substrate 2. Preferably, the first substrate 2 is a transparent glass with less than 0.02 wt% of iron in the form of Fe2O3. According to the invention, the PVB has a value of water vapour transmission rate (WVTR) expressed in g/m²day less than 40 and having a processing temperature lower or equal to 120°C.

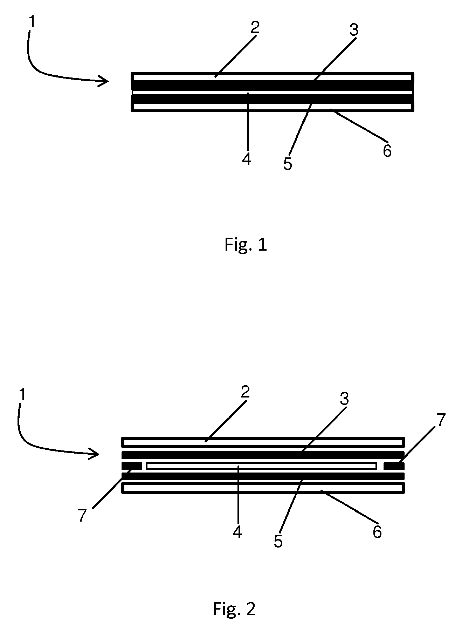

A layer comprising the organic PV component 4 is then added and the electric connections are put. Optionally, a compensation layer of interlayer 7 can be added on the surroundings of the layer with the photovoltaic component to obtain a better aesthetical result, for instance without bubbles, as shown in figure 2.

One or more films 5 of PVB are added on this stack. Optionally, the layer comprising the organic PV molecules is surrounded by a further frame of a film of PVB thermoplastic interlayer. The one or more films of PVB may have a thickness comprised between 0.2 to 1.5 mm and preferably between 0.2 to 1.2 mm. The use of polyvinyl butyral (PVB) as thermoplastic interlayer film allow to prevent the degradation of the film comprising functional PV organic molecules.

The Figure 3 shows the results of the damp heat test realized by using PVB in comparison with EVA or ionomer films as thermoplastic interlayer. Figure 3 shows that PVB is better than that EVA in term of lamination but not ionomer which presents some issues during the lamination realized at a temperature of 120°C.

A second substrate (herein glass) 6 is placed. The second substrate glass may be a lacquered glass for an aesthetic aspect.

According to the present invention, the substrate may be any rigid structure, including plastic or glass. Preferably, the substrate is a glass substrate. The glass substrate used may be flat glass, in particular float glass of various thicknesses; it may be soda lime glass and may be clear, extra-clear, coloured, etched, sand-blasted, patterned or coated glass, or particular compositions for display applications. The glass may be bent. Glass sheets according to the invention may have a size greater than 1m x 1m. They may have various sizes depending on the desired application.

A preferred front glass is a low-absorbing (low iron) glass.

According to another embodiment of the present invention, the glass substrate is a heat treated glass sheet, for example annealed or tempered and/or bended glass sheet. Typically, this involves heating the glass sheet (coated or not) in a furnace to a temperature of at least 580°C, more preferably of at least about 600°C and still more preferably of at least 620°C before rapidly cooling down the glass substrate. This tempering and/or bending can take place for a period of at least 4 minutes, at least 5 minutes, or more in different situations.

The glass may be coated with an anti-reflective coating, an anti-scratch coating.

The lamination process including at least one glass sheet and a thermoplastic interlayer such as PVB is well known.

The obtained assembly displays good PV properties.

## Claims

1. An organic photovoltaic assembly (1) comprising a first glass layer (2), a film comprising a functional organic photovoltaic component (4), at least one thermoplastic interlayer (3), or (5) or (7) and a substrate (6), wherein the thermoplastic interlayers are having a value of water vapour transmission rate expressed in g/m²day less than 40 and having a processing temperature lower or equal to 120°C.

2. The assembly (1) of claim 1, wherein the substrate (6) is a glass.

3. The assembly (1) of claim 1 or 2, wherein the first glass layer (2) is transparent glass, preferably with less than 0.02 wt% of iron expressed in the form of Fe₂O₃.

4. The assembly (1) according to any one of the preceding claims, comprising at least two layers of a thermoplastic interlayer having a value of water vapour transmission rate expressed in g/m²day less than 40 and having a processing temperature lower or equal to 120°C (3) and (5) encapsulating the film comprising the functional photovoltaic (PV) organic molecules (4).

5. The assembly (1) according to any one of the preceding claims, wherein the thermoplastic interlayer having a value of water vapour transmission rate expressed in g/m²day lower or equal to 40 and having a processing temperature less than 120°C is polyvinyl butyral interlayer.

6. The assembly (1) according to any of the preceding claims, wherein the film comprising a functional organic photovoltaic component (4) is flexible.

7. The assembly (1) according to any of the preceding claims, wherein the organic photovoltaic component is an organic photoactive component comprising small molecules in at least one of the photoactive layers.

8. A process for the production of an organic photovoltaic assembly (1) comprising the steps of:
- adding a composition comprising at least one thermoplastic interlayer having a value of water vapour transmission rate expressed in g/m²day less than 40 and having a processing temperature lower or equal to 120°C on a glass substrate (2);
- adding a film comprising organic photoactive component (4);
- adding a second substrate (6) and tightly fixing the obtained stack;
- laminating the at least one thermoplastic interlayer having a value of water vapour transmission rate expressed in g/m²day less than 40 and having a processing temperature lower or equal to 120°C layer in the said stack so as to form thermoplastic interlayer having a value of water vapour transmission rate expressed in g/m²day less than 40 and having a processing temperature lower or equal to 120°C (3) or (5) laminating the said film comprising functional photovoltaic (PV) organic molecules (4).

9. The process of claim 8 wherein at least one thermoplastic interlayer having a value of water vapour transmission rate expressed in g/m²day less than 40 and having a processing temperature lower or equal to 120°C is added between the PV film (4) and the second substrate (6).

10. The process of claim 8 or 9, wherein at least one thermoplastic interlayer having a value of water vapour transmission rate expressed in g/m²day less than 40 and having a processing temperature lower or equal to 120°C compensation layer is added on the surroundings of the PV film (4).

11. The assembly obtainable by the process of any one of the claims 8 to 10.
